# EUROPÄISCHE PATENTSCHRIFT

(11) **EP 4 390 429 B1**
(45) Veröffentlichungstag und Bekanntmachung des Hinweises auf die Patenterteilung: **04.06.2025**
(21) Anmeldenummer: 22216283.6
(22) Anmeldetag: 23.12.2022
(51) Int. Cl.: G01R 33/28, G01R 33/54

(54) **VERFAHREN ZUM BESTIMMEN EINES ABSTANDS EINES PATIENTEN ZU EINER EINEN PATIENTENAUFNAHMEBEREICH UMGEBENDEN UMHAUSUNG**
METHOD FOR DETERMINING A DISTANCE OF A PATIENT TO A HOUSING SURROUNDING THE PATIENT AREA
PROCÉDÉ DE DÉTERMINATION D'UNE DISTANCE D'UN PATIENT À UNE ENCEINTE ENTOURANT UNE ZONE DE RÉCEPTION DE PATIENT

(43) Veröffentlichungstag der Anmeldung: 26.06.2024
(73) Patentinhaber: Siemens Healthineers AG, 91301 Forchheim (DE)
(72) Erfinder: Brinker, Gerhard, 91054 Erlangen (DE); Gebhardt, Matthias, 91052 Erlangen (DE); Grodzki, David, 91058 Erlangen (DE); Groß-Weege, Nicolas, 90459 Nürnberg (DE); Weissenberger, Volker, 91096 Möhrendorf (DE)
(74) Vertreter: Siemens Healthineers Patent Attorneys

(56) Entgegenhaltungen:
- DE-A1- 102012 205 236
- DE-A1- 102015 212 206
- DE-A1- 102018 209 691

## Beschreibung

Die vorliegende Erfindung betrifft ein Verfahren zu einem Ermitteln eines Abstands eines Patienten zu einer einen Patientenaufnahmebereich umgebenden Umhausung einer Magnetresonanzvorrichtung während einer Magnetresonanzuntersuchung. Des Weiteren betrifft die vorliegende Erfindung eine Magnetresonanzvorrichtung, die zu einer Ausführung des Verfahrens zu einem Bestimmen eines Abstands eines Patienten zu einer einen Patientenaufnahmebereich umgebenden Umhausung während einer Magnetresonanzuntersuchung ausgebildet ist. Weiterhin betrifft die vorliegende Erfindung ein Computerprogramm, welches zu einem Ausführen des Verfahrens zu einem Bestimmen eines Abstands eines Patienten zu einer einen Patientenaufnahmebereich umgebenden Umhausung während einer Magnetresonanzuntersuchung ausgebildet ist.

Unabhängig vom grammatikalischen Geschlecht eines bestimmten Begriffes sind Personen mit männlicher, weiblicher oder anderer Geschlechteridentität mit umfasst.

In der Magnetresonanzbildgebung werden Spins eines zu untersuchenden Objekts, beispielsweise eines Patienten, mit resonanten Hochfrequenz-Pulsen (HF-Pulsen) aus ihrer Ruhelage ausgelenkt, um ein messbares Signal zu erzeugen oder eine gezielte Änderung des Kontrastes zu erreichen. Durch das Applizieren der HF-Pulse wird Energie in das zu untersuchende Objekt übertragen, was zu Erwärmungen des Objekts führen kann und durch die "Specific absorption rate" (SAR) beschrieben wird. Hierbei müssen Grenzwerte für SAR eingehalten werden, wobei sich diese Grenzwerte in Abhängigkeit von einer Körperregion unterscheiden. Diese Grenzwerte sind beispielsweise jeweils auf eine Mittelungszeit von 6 Minuten bezogen, und somit unabhängig von der Ablaufdauer eines jeweiligen Mess-Protokolls. Insbesondere bei Magnetresonanzsequenzen, wie beispielsweise SPACE-Sequenz (3D-Turbo-Spin-Echo-Sequence), TSE-Sequenz (Turbo-Spin-Echo-Sequenz), HASTE-Sequenz (Half fourier-Acquired Single shot Turbo spin Echo sequenz) oder auch Messungen mit SMS (Simultaneous Multi Slice), in denen HF-Pulse in schneller Abfolge und mit hohen Amplituden verwendet werden, können hohe SAR-Werte resultieren, welche oberhalb der vorgegebenen Grenzwerte liegen. Dies wird durch eine SAR-Überwachung und Vorhersage erkannt, was dazu führen kann, dass beispielsweise Pausen nach der Messung eingebaut und/oder Flipwinkel oder Schichten reduziert werden müssen.

Neben den SAR-Grenzen für Ganzkörperuntersuchungen und/oder einzelne Körperregionen sollten zudem weitere begrenzende Faktoren bei einer Magnetresonanzuntersuchung eines Patienten berücksichtigt werden. Insbesondere ist hierbei ein Berührschutz, insbesondere ein Abstand des Patienten zu einer den Patientenaufnahmebereich umgebenden Umhausung, insbesondere einer Hochfrequenzantenneneinheit, von Bedeutung. In unmittelbarer Nähe zur Innenwand des Patientenaufnahmebereichs treten lokal deutlich erhöhte HF-Feldamplituden auf (z.B. dort, wo sich direkt hinter der Tunnelwand Kondensatoren befinden). Wird der Patient so gelagert, dass sich Körperteile in einem Raumbereich mit lokal deutlich erhöhten HF-Feldamplituden befinden, so tritt in dem sich dort befindlichen Gewebe eine entsprechend erhöhte Leistungsabsorption auf, so dass trotz Einhaltung der vorgeschriebenen globalen SAR-Grenzen eine HF-Verbrennung möglich ist. Um dieser Gefahr zu begegnen ist generell ein Mindestabstand zu der den Patientenaufnahmebereich umgebenden Umhausung vorgeschrieben, welcher beispielsweise durch Verwendung von Abstandskissen vom Anwender zu realisieren ist. Um beleibte Patienten möglichst nicht von der Untersuchung auszuschließen, sollte dieser Mindestabstand möglichst klein sein - z. B. 5 mm. In Distanzen größer des gewählten Mindestabstandes (z. B. 5 mm) können unter ungünstigen Umständen möglicher Weise trotzdem noch gefährdende Leistungsabsorptionsintensitäten lokal im Gewebe auftreten, so dass selbst bei Einhaltung der vorgeschriebenen globalen SAR Grenzen eine HF-Verbrennung nicht ausgeschlossen werden kann. Um die HF-Verbrennung bei Vorliegen der genannten ungünstigen Umständen zu vermeiden, ist eine Berührschutzfunktion vorgesehen, welche die ungünstigen Umstände detektiert, und die HF-Sendeleistung dann entsprechend limitiert, so dass eine HF-Verbrennung vermieden wird. Ungünstige Umstände liegen beispielsweise dann vor, wenn die Summenströme in den Endringen der Hochfrequenzantenneneinheit besonders hoch sind.

Bisher wird bei Magnetresonanzuntersuchungen angenommen, dass zu einen der Mindestabstand, ggfs. durch Verwendung von Abstandskissen, eingehalten wird und zum anderen, dass sich Gewebe in einem Abstand von nur 5 mm befinden könnte. Dann wird anhand einer Referenzspannung, die im Rahmen einer Justage-messung der Hochfrequenzantenneneinheit ermittelt wird, eine zu applizierende HF-Leistung ermittelt bzw. abgeschätzt. Um HF-Verbrennungen für die möglicherweise vorliegende Position des Patienten nahe der Tunnelwand zu vermeiden, wird die zu applizierende HF-Leistung begrenzt und/oder limitiert. In vielen Fällen wird jedoch der Abstand des Patienten zur Tunnelwand größer sein, so dass diese Limitierung der HF-Leistung unnötig ist.

Aus DE 10 2012 205 236 A1 ist ein Verfahren zum Betrieb einer bilderzeugenden medizinischen Modalität, insbesondere eines Magnetresonanztomographen bekannt. Dieses Verfahren umfasst einen Abstimmungsprozess, bei dem mittels der Modalität ein elektromagnetisches Feld generiert wird und unter Ausnutzung des elektromagnetischen Feldes Bilddaten erzeugt werden, wobei auf der Grundlage der Bilddaten ein Abstand zwischen einem Patienten und einer Wandung der Modalität ermittelt wird.

Aus DE 10 2018 209 691 A1 ist ein Verfahren zu einem automatischen Bestimmen einer Kollisionswahrscheinlichkeit eines auf einer Patientenlagerungsvorrichtung positionierten Objekts mit einem einen Patientenaufnahmebereich einer medizinischen Bildgebungsvorrichtung umgebenden Gehäuse bekannt. Dabei werden zunächst 3D-Positionsdaten der auf der Patientenlagerungsvorrichtung positionierten Objekte mittels einer 3D-Erfassungseinheit erfasst und anschließend die 3D-Positionsdaten mittels einer Auswerteeinheit ausgewertet, wobei das Auswerten der 3D-Positionsdaten hinsichtlich eines Abstands des auf der Patientenlagerungsvorrichtung angeordneten Objekts bezüglich des den Patientenaufnahmebereich umgebenden Gehäuses in radialer Richtung erfolgt. In Abhängigkeit des Abstands erfolgt ein Bestimmen der Kollisionswahrscheinlichkeit.

Der vorliegenden Erfindung liegt insbesondere die Aufgabe zugrunde, eine genaue Bestimmung eines Abstands des Patienten zu einer den Patientenaufnahmebereich umgebenden Umhausung für einen Berührschutz des Patienten während einer Magnetresonanzuntersuchung bereitzustellen. Die Aufgabe wird durch die Merkmale der unabhängigen Ansprüche gelöst. Vorteilhafte Ausgestaltungen sind in den Unteransprüchen beschrieben.

Die Erfindung geht aus von einem Verfahren zu einem Ermitteln eines Abstands eines Patienten zu einer einen Patientenaufnahmebereich umgebenden Umhausung einer Magnetresonanzvorrichtung während einer Magnetresonanzuntersuchung umfassend die folgenden Verfahrensschritte:
- Bereitstellen einer ersten Größeninformation des Patienten, wobei die erste Größeninformation vor Beginn der Magnetresonanzuntersuchung bereitgestellt wird,
- Erfassen von Magnetresonanzdaten des Patienten während der Magnetresonanzuntersuchung und Bestimmen einer zweiten Größeninformation des Patienten anhand der erfassten Magnetresonanzdaten, und
- Ermitteln des Abstand des Patienten zu der den Patientenaufnahmebereich umgebenden Umhausung anhand der ersten Größeninformation des Patienten und anhand der zweiten Größeninformation des Patienten.

Die Magnetresonanzvorrichtung umfasst bevorzugt eine medizinische und/oder diagnostische Magnetresonanzvorrichtung, die zu einem Erfassen von medizinischen und/oder diagnostischen Bilddaten, insbesondere medizinischen und/oder diagnostischen Magnetresonanzbilddaten, eines Patienten ausgelegt und/oder ausgebildet ist. Zudem kann die erfindungsgemäße Magnetresonanzvorrichtung zusammen mit einer PET-Vorrichtung (Positron-Emission-Tomographie-Vorrichtung) auch in ein kombiniertes Magnetresonanz-PET-System integriert sein.

Die Magnetresonanzvorrichtung umfasst eine Scannereinheit. Die Scannereinheit der Magnetresonanzvorrichtung umfasst bevorzugt eine Magneteinheit zur Erfassung der medizinischen und/oder diagnostischen Bilddaten. Hierbei umfasst die Scannereinheit, insbesondere die Magneteinheit, einen Grundmagneten, eine Gradientenspuleneinheit und eine Hochfrequenzantenneneinheit. Die Hochfrequenzantenneneinheit ist hierbei fest innerhalb der Scannereinheit angeordnet.

Der Grundmagnet ist zur Erzeugung eines homogenen Grundmagnetfelds mit einer definierten Magnetfeldstärke, wie beispielsweise mit einer Magnetfeldstärke von 0,55 T oder 1,5 T oder 3 T oder 7 T usw., ausgebildet. Insbesondere ist der Grundmagnet zur Erzeugung eines starken, konstanten und homogenen Grundmagnetfelds ausgebildet. Das homogene Grundmagnetfeld ist bevorzugt innerhalb eines Patientenaufnahmebereichs der Magnetresonanzvorrichtung angeordnet und/oder vorzufinden. Das Gradienten-System ist zu einer Erzeugung von Magnetfeldgradienten, die für eine Ortskodierung während einer Bildgebung verwendet werden, ausgebildet.

Für eine Magnetresonanzuntersuchung wird der Patient, insbesondere der zu untersuchende Bereich des Patienten, innerhalb des Patientenaufnahmebereichs der Magnetresonanzvorrichtung positioniert. Der Patientenaufnahmebereich ist dabei zumindest teilweise von der Scannereinheit umgeben, insbesondere zylinderförmig von der Scannereinheit umgeben. Die den Patientenaufnahmebereich umgebende Umhausung kann dabei einstückig und/oder einteilig mit der Hochfrequenzantenneneinheit der Scannereinheit ausgebildet sein, beispielsweise in dem die den Patientenaufnahmebereich umgebende Umhausung eine dem Patientenaufnahmebereich zugewandte Seite der Hochfrequenzantenneneinheit umfasst.

Innerhalb des Patientenaufnahmebereichs ist bevorzugt ein Field of View (FOV) und/oder ein Isozentrum der Magnetresonanzvorrichtung angeordnet. Das FOV umfasst bevorzugt einen Erfassungsbereich der Magnetresonanzvorrichtung, innerhalb dessen die Bedingungen für eine Erfassung von medizinischen Bilddaten, insbesondere Magnetresonanzbilddaten, innerhalb des Patientenaufnahmebereichs vorliegen, wie beispielsweise ein homogenes Grundmagnetfeld. Das Isozentrum der Magnetresonanzvorrichtung umfasst bevorzugt den Bereich und/oder Punkt innerhalb der Magnetresonanzvorrichtung, der die optimalen und/oder idealen Bedingungen für die Erfassung von medizinischen Bilddaten, insbesondere Magnetresonanzbilddaten, aufweist. Insbesondere umfasst das Isozentrum den homogensten Magnetfeldbereich innerhalb der Magnetresonanzvorrichtung.

Die Magnetresonanzvorrichtung umfasst zudem eine Systemsteuereinheit, wobei die Systemsteuereinheit zumindest ein Rechenmodul und/oder einen Prozessor umfasst. Die Systemsteuereinheit ist dazu ausgebildet, die einzelnen Komponenten der Magnetresonanzvorrichtung für zumindest eine Magnetresonanzdatenerfassung und/oder eine Magnetresonanzdatenrekonstruktion anzusteuern. Dabei werden von der Systemsteuereinheit entsprechende Steuerbefehle und/oder Steuerdaten für die einzelnen Komponenten der Magnetresonanzvorrichtung in Abhängigkeit von einer mittels des Prozessors und/oder des Rechenmoduls ausgeführten Software generiert.

So ist insbesondere die Systemsteuereinheit dazu ausgebildet, computerlesbare Instruktionen zur Ansteuerung der einzelnen Komponenten der Magnetresonanzvorrichtung auszuführen. Insbesondere umfasst die Systemsteuereinheit eine Speichereinheit, wobei auf der Speichereinheit computerlesbare Informationen gespeichert sind, wobei die Systemsteuereinheit dazu ausgebildet ist, die computerlesbaren Informationen von der Speichereinheit zu laden und die computerlesbaren Informationen zur Ansteuerung der einzelnen Komponenten der Magnetresonanzvorrichtung auszuführen. Die Komponenten der Systemsteuereinheit können zum überwiegenden Teil in Form von Softwarekomponenten ausgebildet sein. Grundsätzlich können diese Komponenten aber auch zum Teil, insbesondere wenn es um besonders schnelle Berechnungen geht, in Form von softwareunterstützten Hardwarekomponenten, beispielsweise FPGAs oder dergleichen, realisiert sein. Selbstverständlich ist es auch denkbar, dass mehrere der genannten Komponenten in Form einer einzelnen Softwarekomponente bzw. softwareunterstützter Hardwarekomponente zusammengefasst realisiert sind.

Die Magnetresonanzuntersuchung umfasst bevorzugt dabei zumindest eine Sequenz für eine Magnetresonanzdatenerfassung. Eine Sequenz für eine Magnetresonanzuntersuchung umfasst insbesondere eine logische Abfolge von Hochfrequenz-Pulsen (HF-Pulsen), Gradientenpulsen und Aufnahme-Zeiträumen zur Steuerung der Datenaufnahme für eine Magnetresonanzdatenerfassung für eine medizinische und/oder diagnostische Befundung. Eine Magnetresonanzuntersuchung an einem Patienten kann dabei eine Abfolge von mehreren Sequenzen umfassen.

Die erste Größeninformation des Patienten wird bereits vor Beginn der Magnetresonanzuntersuchung bereitgestellt. Dabei kann die erste Größeninformation bereits bei einer Patientenregistrierung erfasst und anschließend bereitgestellt werden. Zudem kann die erste Größeninformation bereits in einem Speicher und/oder einer Datenbank hinterlegt sein, beispielsweise bei einer ersten Größeninformation, die bei einer Voruntersuchung und/oder einer vorherigen Untersuchung ermittelt wurde. Zudem kann die erste Größeninformation auch während einer Vorbereitung der Magnetresonanzuntersuchung erfasst und bereitgestellt werden. Die Magnetresonanzuntersuchung startet und/oder beginnt erst, wenn der Patient zusammen mit dem Patiententisch in den Patientenaufnahmebereich eingefahren ist und in einer Untersuchungsposition innerhalb des Patientenaufnahmebereichs positioniert ist.

Die erste Größeninformation umfasst hierbei bevorzugt eine Ausdehnung des Patienten, insbesondere eine Ausdehnung des Patienten in Querrichtung des Patiententischs. Insbesondere ist hierbei eine Ausdehnung desjenigen Bereichs des Patienten von Bedeutung, der während der Magnetresonanzuntersuchung innerhalb des Patientenaufnahmebereichs angeordnet ist. Insbesondere umfasst die erste Größeninformation des Patienten eine Größeninformation und/oder Ausdehnungsinformation und/oder einen Umriss des Patienten, die in Querrichtung des Patiententischs außerhalb des FOVs angeordnet ist. Bevorzugt erfolgt das Bereitstellen der ersten Größeninformation des Patienten mittels einer Bereitstellungseinheit der Magnetresonanzvorrichtung. Die Bereitstellungseinheit kann dabei eine Kamera und/oder eine Datenbank und/oder eine Steuereinheit und/oder weitere, dem Fachmann als sinnvoll erscheinende Einheiten umfassen.

Das Erfassen von Magnetresonanzdaten zur Bestimmung der zweiten Größeninformation des Patienten erfolgt während der Magnetresonanzuntersuchung. Das Erfassen der Magnetresonanzdaten erfolgt hierbei mittels einer Erfassungseinheit, wobei die Erfassungseinheit die Scannereinheit der Magnetresonanzvorrichtung umfasst. Das Erfassen von Magnetresonanzdaten zur Bestimmung der zweiten Größeninformation des Patienten kann dabei bevorzugt spezielle Justagemessungen umfassen, aus denen die zweite Größeninformation des Patienten bestimmt werden kann. Bevorzugt werden derartige Justagemessungen in Messpausen und/oder zwischen einzelnen Hochfrequenzpulsen der Magnetresonanzuntersuchung durchgeführt. Auch kann zu Beginn der Magnetresonanzuntersuchung eine derartige Justagemessung durchgeführt werden. Jedoch kann mittels der Magnetresonanzdaten nicht die gesamte Ausdehnung des Patienten in Querrichtung des Patiententischs ermittelt und/oder bestimmt werden. Die zweite Größeninformation beschränkt sich hierbei auf das FOV der Magnetresonanzvorrichtung und umfasst den zu untersuchenden Bereich des Patienten und die um den zu untersuchenden Bereich angeordneten Bereiche des Patienten. Insbesondere enthält die zweite Größeninformation eine Position des zu untersuchenden Bereichs und/oder eine Anatomie des Patienten innerhalb des FOVs.

Zur Bestimmung und/oder Ermittlung der zweiten Größeninformation werden aus den erfassten Magnetresonanzdaten Magnetresonanzbilder rekonstruiert. Bevorzugt umfasst hierbei die zweiten Größeninformation des Patienten Magnetresonanzbilddaten des Patienten.

Das Ermitteln des Abstands des Patienten zu der den Patienten zu der den Patientenaufnahmebereich umgebenden Umhausung, insbesondere der Hochfrequenzantenneneinheit, erfolgt bevorzugt mittels einer Ermittlungseinheit. Die Ermittlungseinheit kann dabei eine Recheneinheit und/oder eine Steuereinheit umfassen. Insbesondere wird hierbei von der Ermittlungseinheit ausgehend von der ersten Größeninformation und der zweiten Größeninformation ein Körpermodell des Patienten ermittelt und/oder berechnet, wie beispielsweise ein virtuelles Körpermodell. Das Körpermodell beschränkt sich dabei auf den innerhalb des Patientenaufnahmebereich befindlichen Teilbereich des Patienten. Umfasst beispielsweise die zweite Größeninformation Magnetresonanzbilddaten des Torsos des Patienten, der innerhalb des FOVs angeordnet ist, kann durch die erste Größeninformation, die beispielsweise eine Ausdehnung und/oder Lage der Arme des Patienten umfasst, ein Gesamtbild des innerhalb des Patientenaufnahmebereichs befindlichen Teilbereichs des Patienten erstellt werden.

Zudem kann auch das Ermitteln des Abstands des Patienten zu der den Patientenaufnahmebereich umgebenden Umhausung, insbesondere der Hochfrequenzantenneneinheit, mittels eines maschinellen Lernverfahrens, auch Deep-Learning Verfahren genannt, erfolgen, welches auf dem künstlichen neuronalen Netz basiert. Ein künstliches neuronales Netz (KNN, englisch artificial neural network- ANN) ist insbesondere ein in einem Rechenprogramm nachgebildetes Netz aus künstlichen Neuronen. Das künstliche neuronale Netz basiert dabei typischerweise auf einer Vernetzung von mehreren künstlichen Neuronen. Die künstlichen Neuronen sind dabei typischerweise auf verschiedenen Schichten (layers) angeordnet. Üblicherweise umfasst das künstliche neuronale Netz eine Eingangsschicht und eine Ausgabeschicht (output layer), deren Neuronenausgabe als einzige des künstlichen neuronalen Netzes sichtbar wird. Zwischen der Eingangsschicht und der Ausgabeschicht liegende Schichten werden typischerweise als verdeckte Schichten (hidden layer) bezeichnet. Typischerweise wird zunächst eine Architektur und/oder Topologie eines künstlichen neuronalen Netzes initiiert und dann in einer Trainingsphase für eine spezielle Aufgabe oder für mehrere Aufgaben in einer Trainingsphase trainiert. Das Training des künstlichen neuronalen Netzes umfasst dabei typischerweise eine Veränderung einer Gewichtung einer Verbindung zwischen zwei künstlichen Neuronen des künstlichen neuronalen Netzes. Das Training des künstlichen neuronalen Netzes kann auch eine Entwicklung von neuen Verbindungen zwischen künstlichen Neuronen, ein Löschen von bestehenden Verbindungen zwischen künstlichen Neuronen, ein Anpassen von Schwellwerten der künstlichen Neuronen und/oder ein Hinzufügen oder ein Löschen von künstlichen Neuronen umfassen. Das künstliche neuronale Netz wurde insbesondere im Vorfeld bereits geeignet für die Ermittlung des Abstands des Patienten zu der den Patientenaufnahmebereich umgebenden Umhausung, insbesondere der Hochfrequenzantenneneinheit, trainiert.

Die Erfindung weist den Vorteil auf, dass eine exakte Bestimmung des Abstands des Patienten zu der den Patientenaufnahmebereich umgebenden Umhausung, insbesondere der Hochfrequenzantenneneinheit, erreicht werden kann. Zudem kann derart auch eine hohe Sicherheit für den Patienten während der Magnetresonanzuntersuchung bereitgestellt werden. Damit können auch Sicherheitsmaßnahmen, beispielsweise ein Beschränken und/oder ein Reduzieren einer HF-Leistung der auszuspielenden HF-Pulse, erst eingeleitet werden, wenn der Abstand zwischen dem Patienten und der den Patientenaufnahmebereich umgebenen Umhausung tatsächlich unterhalb eines Schwellwerts, beispielsweise kleiner 5 mm liegt und damit auch auf unnötige Beschränkungen der HF-Leistung während der Magnetresonanzuntersuchung verzichtet werden. Damit können auch unnötigen Beschränkungen der HF-Leitung vermieden werden.

In einer vorteilhaften Weiterbildung des erfindungsgemäßen Verfahrens kann es vorgesehen sein, dass die erste Größeninformation mittels einer Kamera bereitgestellt wird. Bevorzugt umfasst hierbei die Bereitstellungseinheit die Kamera. Die Kamera kann dabei eine 2D-Kamera oder eine 3D-Kamera umfassen. Besonders vorteilhaft ist hierbei die Kamera an einer Frontseite der Magnetresonanzvorrichtung, insbesondere der Scannereinheit, angeordnet. Zudem kann die Kamera auch in einem in Einfahrtsrichtung des Patiententisch vor dem Patientenaufnahmebereich angeordneten Bereich angeordnet sein, wie beispielsweise an der Decke des vor dem Patientenaufnahmebereich angeordneten Bereichs. Diese Ausgestaltung der Erfindung weist den Vorteil auf, dass auf einfache Art und Weise stets eine aktuelle und/oder genaue erste Größeninformation des Patienten bereitgestellt werden kann.

In einer vorteilhaften Weiterbildung des erfindungsgemäßen Verfahrens kann es vorgesehen sein, dass die erste Größeninformation mittels einer Datenbank und/oder einer Patientenregistrierung bereitgestellt wird. Bevorzugt umfasst hierbei die Bereitstellungseinheit die Datenbank und/oder eine Recheneinheit mit einer Benutzerschnittstelle zur Erfassung der Patientenregistrierung. Beispielsweise können in der Datenbank erste Größeninformationen aus vorherigen Untersuchungen gespeichert sein. Zudem kann auch bei der Patientenregistrierung eine erste Größeninformation des Patienten erfasst werden und für die Ermittlung des Abstands des Patienten zu der den Patientenaufnahmebereich umgebenden Umhausung, insbesondere der Hochfrequenzantenneneinheit, bereitgestellt werden. Bei der Patientenregistrierung wird vor der Magnetresonanzuntersuchung des Patienten durchgeführt, wobei hierbei alle für die Magnetresonanzuntersuchung relevanten Daten vom Patienten erfasst werden. Derart können besonders schnell bereits vorhandene Daten, insbesondere erste Größeninformationen, des Patienten für die Ermittlung eines Abstands des Patienten zu der den Patientenaufnahmebereich umgebenden Umhausung, insbesondere der Hochfrequenzantenneneinheit, bereitgestellt werden.

In einer vorteilhaften Weiterbildung des erfindungsgemäßen Verfahrens kann es vorgesehen sein, dass die erste Größeninformation einen Bereich in zumindest eine Raumrichtung umfasst, wobei dieser Bereich in der zumindest einen Raumrichtung außerhalb des FOVs der Magnetresonanzvorrichtung angeordnet ist. Bevorzugt umfasst die zumindest eine Raumrichtung eine Querrichtung des Patiententisch der Patientenlagerungsvorrichtung. Der Patiententisch wird bevorzugt in Längsrichtung des Patiententischs in den Patientenaufnahmebereich eingefahren. Die Querrichtung ist dabei senkrecht zur Längsrichtung des Patiententischs ausgerichtet. In Querrichtung grenzt der Patiententisch beidseitig an die den Patientenaufnahmebereich umgebende Umhausung, insbesondere an die Hochfrequenzantenneneinheit. Das FOV einer Magnetresonanzvorrichtung ist um das Isozentrum angeordnet und umfasst nur einen Teilbereich, insbesondere einen zentralen Bereich, des Patientenaufnahmebereichs. In die zumindest eine Raumrichtung, insbesondere in Querrichtung des Patiententischs, deckt das FOV dabei nicht den gesamten Patientenaufnahmebereich ab. Hingegen enthält die erste Größeninformation des Patienten einen Bereich des Patienten, der über das FOV in die zumindest eine Raumrichtung, insbesondere die Querrichtung des Patiententischs, hinausgeht. Dieser Bereich deckt vorzugsweise in die zumindest eine Raumrichtung auch einen Randbereich des Patientenaufnahmebereichs ab, der in der zumindest einen Raumrichtung außerhalb des FOVs angeordnet ist.

Diese Ausgestaltung der Erfindung weist den Vorteil auf, dass durch beiden Größeninformationen, insbesondere der ersten Größeninformation und der zweiten Größeninformation, eine komplette Erfassung einer Ausdehnung des Patienten für die Bestimmung des Abstand des Patienten zu der den Patientenaufnahmebereich umgebenden Umhausung, insbesondere der Hochfrequenzantenneneinheit, bereitgestellt werden kann. Insbesondere wird durch die zweite Größeninformation eine Position des Patienten bezüglich des Isozentrums bestimmt und mittels der ersten Größeninformation das Patientenmodell, beispielsweise ein virtuelles Patientenmodell vervollständigt.

In einer vorteilhaften Weiterbildung des erfindungsgemäßen Verfahrens kann es vorgesehen sein, dass das Erfassen von Magnetresonanzdaten zur Bestimmung der zweiten Größeninformation des Patienten mit einem maximalen FOV durchgeführt wird. Das maximale FOV einer Magnetresonanzvorrichtung umfasst hierbei bevorzugt ein gerätespezifisches maximales FOV. Bevorzugt ist das maximale FOV in der koronalen Ebene maximal ausgerichtet. Beispielsweise kann ein derartiges maximale FOV in z-Richtung 50 cm und in x-Richtung und y-Richtung jeweils 45 cm betragen. Die z-Richtung entspricht dabei der Längsrichtung des Patientenaufnahmebereichs, die x-Richtung verläuft in horizontaler Richtung ist senkrecht zur z-Richtung und die y-Richtung verläuft in vertikaler Richtung und ist senkrecht zur z-Richtung und senkrecht zur x-Richtung. Bevorzugt werden zum Erfassen der Magnetresonanzdaten zur Bestimmung der zweiten Größeninformation des Patienten in z-Richtung mehrere Schichten angeregt und Magnetresonanzdaten dieser mehreren Schichten erfasst. Derart kann ein großes Übersichtsbild zur Bestimmung einer Position des Patienten und damit auch der Abstands des Patienten zu der den Patientenaufnahmebereich umgebenden Umhausung, insbesondere der Hochfrequenzantenneneinheit, bereitgestellt werden. Zudem kann es sein, dass das Erfassen von Magnetresonanzdaten zur Bestimmung der zweiten Größeninformation des Patienten mit einer geringen Auflösung, insbesondere einer geringeren Ortsauflösung erfolgt als das Erfassen von medizinischen und/oder diagnostischen Magnetresonanzdaten und/oder Bilddaten, so dass das Erfassen der Magnetresonanzdaten zur Bestimmung der zweiten Größeninformation des Patienten besonders zeitsparend und schnell durchgeführt werden kann.

In einer vorteilhaften Weiterbildung des erfindungsgemäßen Verfahrens kann es vorgesehen sein, dass das Erfassen der Magnetresonanzdaten zur Bestimmung der zweiten Größeninformation des Patienten für einen für die Magnetresonanzuntersuchung relevanten Bereich des Patienten durchgeführt wird. Der für die Magnetresonanzuntersuchung relevante Bereich des Patienten ist bevorzugt im FOV des Patienten angeordnet, so dass eine einfache Erfassung der Magnetresonanzdaten zur Bestimmung der zweiten Größeninformation des Patienten erreicht werden kann. Insbesondere kann derart auch eine exakte Positionsbestimmung des zu untersuchenden Bereichs innerhalb des FOVs bereitgestellt werden und damit auch der Abstands des Patienten zu der den Patientenaufnahmebereich umgebenden Umhausung, insbesondere der Hochfrequenzantenneneinheit, besonders exakt bestimmt werden.

In einer vorteilhaften Weiterbildung des erfindungsgemäßen Verfahrens kann es vorgesehen sein, dass das Erfassen der Magnetresonanzdaten zur Bestimmung der zweiten Größeninformation des Patienten eine Justage-Messung und/oder eine Lokalisier-Messung umfasst. Eine Lokalisier-Messung und/oder Justage-Messung umfasst bevorzugt eine Messung und/oder einen Scan mit einer geringen Auflösung, insbesondere einer geringen Ortsauflösung, und ist dazu ausgebildet, den Patienten und/oder dessen Anatomie innerhalb des FOV zu lokalisieren. Aufgrund der geringen Auflösung kann eine derartige Messung, insbesondere die Justage-Messung und/oder die Lokalisier-Messung, besonders zeitsparend durchgeführt werden. Insbesondere kann eine derartiger Justage-Messung und/oder Lokalisier-Messung besonders zeitsparend in Messpausen zwischen zwei Scans und/oder Sequenzen zur Erfassung von medizinischen und/oder diagnostischen Magnetresonanzdaten durchgeführt werden.

Alternativ oder zusätzlich können die Magnetresonanzdaten zur Bestimmung der zweiten Größeninformation des Patienten zusammen mit medizinischen und/oder diagnostischen Magnetresonanzdaten erfasst werden. Derart kann auf zusätzlich Messungen und/oder Scans zum Erfassen der Magnetresonanzdaten zur Bestimmung der zweiten Größeninformation des Patienten verzichtet werden und somit die zweite Größeninformation des Patienten besonders zeitsparend bereitgestellt werden.

In einer vorteilhaften Weiterbildung des erfindungsgemäßen Verfahrens kann es vorgesehen sein, dass das Erfassen der Magnetresonanzdaten zur Bestimmung der zweiten Größeninformation des Patienten bis zum Beenden der Magnetresonanzuntersuchung wenigstens einmal wiederholt wird. Bevorzugt wird das Erfassen der Magnetresonanzdaten zur Bestimmung der zweiten Größeninformation des Patienten in regelmäßigen Zeitabständen und/oder in vorhandenen Messpausen der Magnetresonanzuntersuchung wiederholt durchgeführt. Insbesondere erfolgt dabei das Erfassen der Magnetresonanzdaten zur Bestimmung der zweiten Größeninformation des Patienten zweimal oder öfter. Derart kann vorteilhaft eine stetige Überwachung der Position des Patienten und damit auch ein stetige Korrektur bei der Bestimmung des Abstands des Patienten zu der den Patientenaufnahmebereich umgebenden Umhausung, insbesondere der Hochfrequenzantenneneinheit, während der Magnetresonanzuntersuchung erfolgen, wie dies beispielsweise bei Bewegungen des Patienten von Vorteil ist.

Erfindungsgemäss ist vorgesehen, dass zum Bestimmen des Abstand des Patienten zu der den Patientenaufnahmebereich umgebenden Umhausung, insbesondere der Hochfrequenzantenneneinheit, ein Körpermodell des Patienten anhand der ersten Größeninformation des Patienten und anhand der zweiten Größeninformation des Patienten bestimmt wird. Das Körpermodell wird bevorzugt dabei von einem innerhalb des Patientenaufnahmebereichs angeordneten Teilbereichs des Patienten erstellt und/oder bestimmt. Bevorzugt umfasst dabei das Körpermodell des Patienten eine Kontur und/oder einen Umriss und/oder eine Oberfläche des innerhalb des Patientenaufnahmebereich angeordneten und/oder befindlichen Teilbereichs des Patienten. Das Körpermodell kann dabei ein 2D-Körpermodell oder ein 3D-Körpermodell umfassen. Insbesondere kann für das Körpermodell als Basis die zweite Größeninformation, insbesondere der Magnetresonanzbilddaten dienen, die durch die erste Größeninformation ergänzt werden. Beispielsweise kann aus der ersten Größeninformation, insbesondere aus den Magnetresonanzbilddaten, des Patienten eine sichtbare innere Armgrenze bestimmt werden, an der ein aus der ersten Größeninformation ermittelten Armdurchmesser dazu addiert werden kann, um eine Information über den gesamten Körper des Patienten und dessen äußere Kontur zu erhalten. Mittels des Körpermodells kann besonders exakt und schnell ein Abstand des Patienten zu der den Patientenaufnahmebereich umgebenden Umhausung, insbesondere der Hochfrequenzantenneneinheit, bestimmt und/oder ermittelt werden.

In einer vorteilhaften Weiterbildung des erfindungsgemäßen Verfahrens kann es vorgesehen sein, dass der ermittelte Abstand des Patienten zu der den Patientenaufnahmebereich umgebenden Umhausung, insbesondere der Hochfrequenzantenneneinheit, mit einem Sicherheitsabstand verglichen wird und, sofern der ermittelte Abstand kleiner ist als der Sicherheitsabstand, zumindest eine Sicherheitsmaßnahme durchgeführt wird. Der Sicherheitsabstand umfasst bevorzugt einen minimalen Abstand des Patienten zu der den Patientenaufnahmebereich umgebenden Umhausung, insbesondere der Hochfrequenzantenneneinheit. Beispielsweise kann der Sicherheitsabstand des Patienten zu der den Patientenaufnahmebereich umgebenden Umhausung, insbesondere der Hochfrequenzantenneneinheit, 5 mm betragen. Die zumindest eine Sicherheitsmaßnahme umfasst bevorzugt eine Reduzierung der HF-Leistung während der Magnetresonanzuntersuchung. Dies kann beispielsweise zu Pausen nach jeder Messung führen und/oder zu einer Reduzierung einer Schichtanzahl und/oder einer Reduzierung der Flipwinkel usw. führen. Zudem kann die zumindest eine Sicherheitsmaßnahme einen Start der Magnetresonanzuntersuchung verhindern, bis der Abstand des Patienten zu der den Patientenaufnahmebereich umgebenden Umhausung größer als der Sicherheitsabstand ist. Alternativ oder zusätzlich kann die zumindest eine Sicherheitsmaßnahme auch eine Warnmeldung und/oder eine Handlungsanweisung, beispielsweise ein Umpositionieren des Patienten zu veranlassen, an das medizinische Bedienpersonal umfassen. Wird dagegen der Sicherheitsabstand des Patienten zu der den Patientenaufnahmebereich umgebenden Umhausung, insbesondere der Hochfrequenzantenneneinheit, eingehalten, kann die Magnetresonanzuntersuchung wie geplant durchgeführt werden. Zudem kann die zumindest eine Sicherheitsmaßnahme wieder aufgehoben werden, sobald der Abstand des Patienten zu der den Patientenaufnahmebereich umgebenen Umhausung wieder größer als der Sicherheitsabstand ist.

Des Weiteren geht die Erfindung aus von einer Magnetresonanzvorrichtung, die zu einem Ausführen eines Verfahren zu einem Bestimmen eines Abstands eines Patienten zu einer einen Patientenaufnahmebereich umgebenden Umhausung während einer Magnetresonanzuntersuchung ausgebildet ist, umfassend:
- eine Bereitstellungseinheit, die zu einem Bereitstellen einer ersten Größeninformation des Patienten ausgebildet ist,
- eine Erfassungseinheit, die zu einem Erfassen von Magnetresonanzdaten zur Bestimmung einer zweiten Größeninformation des Patienten ausgebildet ist, und
- eine Ermittlungseinheit, die zu einem Ermitteln eines Abstands des Patienten zu der den Patientenaufnahmebereich umgebenden Umhausung, insbesondere der Hochfrequenzantenneneinheit, ausgebildet ist.

Die erfindungsgemäße Magnetresonanzvorrichtung weist den Vorteil auf, dass eine exakte Bestimmung des Abstands des Patienten zu der den Patientenaufnahmebereich umgebenden Umhausung, insbesondere der Hochfrequenzantenneneinheit, erreicht werden kann. Zudem kann derart auch eine hohe Sicherheit für den Patienten während der Magnetresonanzuntersuchung bereitgestellt werden. Damit können auch Sicherheitsmaßnahmen, beispielsweise ein Beschränken und/oder ein Reduzieren einer HF-Leistung der auszuspielenden HF-Pulse, erst eingeleitet werden, wenn der Abstand zwischen dem Patienten und der den Patientenaufnahmebereich umgebenen Umhausung tatsächlich unterhalb eines Schwellwerts, beispielsweise kleiner 5 mm liegt und damit auch auf unnötige Beschränkungen der HF-Leistung während der Magnetresonanzuntersuchung verzichtet werden. Damit können auch unnötigen Beschränkungen der HF-Leitung vermieden werden.

Die Vorteile der erfindungsgemäßen Magnetresonanzvorrichtung entsprechen im Wesentlichen den Vorteilen des erfindungsgemäßen Verfahrens zu einem Ermitteln eines Abstands eines Patienten zu einer einen Patientenaufnahmebereich umgebenden Umhausung einer Magnetresonanzvorrichtung während einer Magnetresonanzuntersuchung, welche vorab im Detail ausgeführt sind. Hierbei erwähnte Merkmale, Vorteile oder alternative Ausführungsformen können ebenso auf die anderen beanspruchten Gegenstände übertragen werden und umgekehrt.

Des Weiteren geht die Erfindung aus von einem Computerprogrammprodukt, welches ein Computerprogramm und/oder Steuerprogramm umfasst und direkt in einem Speicher einer programmierbaren Steuereinheit ladbar ist, mit Programmmitteln, um ein Verfahren zu einem Ermitteln eines Abstands eines Patienten zu einer einen Patientenaufnahmebereich umgebenden Umhausung einer Magnetresonanzvorrichtung während einer Magnetresonanzuntersuchung zu steuern, wenn das Computerprogramm und/oder Steuerprogramm in der Steuereinheit ausgeführt wird. Dabei benötigt das Computerprogramm und/oder Steuerprogramm eventuell Programmmittel, z.B. Bibliotheken und Hilfsfunktionen, um die entsprechenden Ausführungsformen des Verfahrens zu realisieren. Das Computerprogramm und/oder Steuerprogramm kann dabei eine Software mit einen Quellcode, der noch compiliert und gebunden oder der nur interpretiert werden muss, oder einen ausführbaren Softwarecode umfassen, der zur Ausführung nur noch in eine entsprechende Recheneinheit zu laden ist. Die Steuereinheit muss dabei jeweils die Voraussetzungen wie beispielsweise einen entsprechenden Arbeitsspeicher, eine entsprechende Grafikkarte oder eine entsprechende Logikeinheit aufweisen, so dass die jeweiligen Verfahrensschritte effizient ausgeführt werden können. Das Computerprogrammprodukt ist beispielsweise auf einem computerlesbaren Medium gespeichert oder auf einem Netzwerk oder Server hinterlegt, von wo es in den Prozessor einer lokalen Recheneinheit geladen werden kann, der mit der Magnetresonanzvorrichtung direkt verbunden oder als Teil ausgebildet sein kann. Weiterhin können Steuerinformationen des Computerprogrammprodukts auf einem elektronisch lesbaren Datenträger gespeichert sein. Die Steuerinformationen des elektronisch lesbaren Datenträgers können derart ausgestaltet sein, dass sie bei Verwendung des Datenträgers in einer Recheneinheit die einzelnen Verfahrensschritte erfindungsgemäßes Verfahren ausführen und/oder deren Ausführung steuern. So kann das Computerprogrammprodukt auch den elektronisch lesbaren Datenträger darstellen. Beispiele für elektronisch lesbare Datenträger sind eine DVD, ein Magnetband, eine Festplatte oder ein USB-Stick, auf welchem elektronisch lesbare Steuerinformationen, insbesondere Software (vgl. oben), gespeichert ist.

Weitere Vorteile, Merkmale und Einzelheiten der Erfindung ergeben sich aus dem im Folgenden beschriebenen Ausführungsbeispiel sowie anhand der Zeichnungen.

Es zeigen:
- Fig. 1: eine erfindungsgemäße Magnetresonanzvorrichtung in einer schematischen Darstellung,
- Fig. 2: ein erfindungsgemäßes Verfahren zu einem Ermitteln eines Abstands eines Patienten zu einer einen Patientenaufnahmebereich umgebenden Umhausung einer Magnetresonanzvorrichtung während einer Magnetresonanzuntersuchung, und
- Fig. 3: ein Querschnitt durch einen Patientenaufnahmebereich der Magnetresonanzvorrichtung.

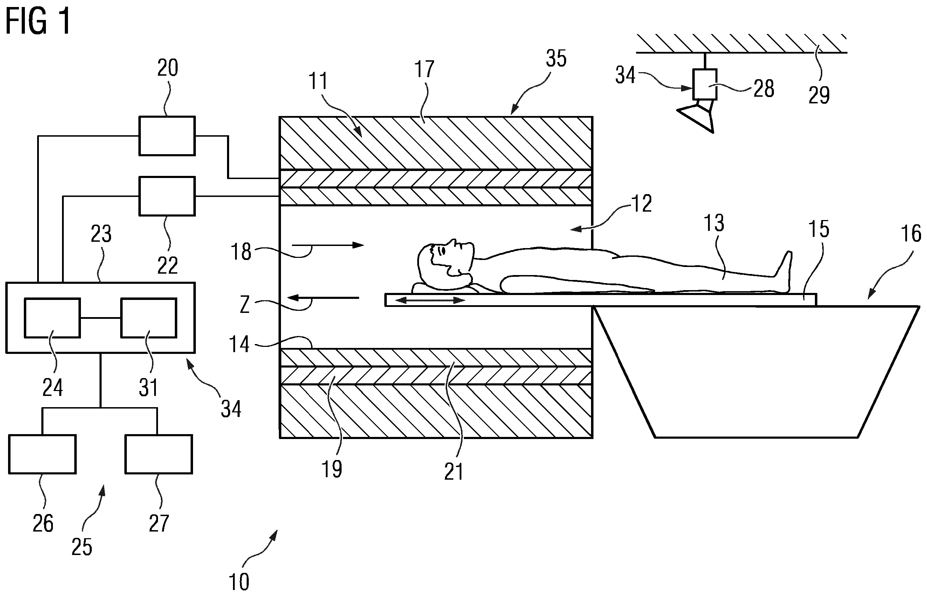

In Fig. 1 ist eine Magnetresonanzvorrichtung 10 schematisch dargestellt. Die Magnetresonanzvorrichtung 10 umfasst eine von einer Magneteinheit gebildeten Scannereinheit 11. Zudem weist die Magnetresonanzvorrichtung 10 einen Patientenaufnahmebereich 12 auf zu einer Aufnahme eines Patienten 13. Der Patientenaufnahmebereich 12 im vorliegenden Ausführungsbeispiel ist zylinderförmig ausgebildet und in einer Umfangsrichtung von der Scannereinheit 11, insbesondere von der Magneteinheit, zylinderförmig umgeben. Die Scannereinheit 11 weist des Weiteren eine den Patientenaufnahmebereich 12 umgebende Umhausung 14 auf. Grundsätzlich ist jedoch eine davon abweichende Ausbildung des Patientenaufnahmebereichs 12 jederzeit denkbar.

Der Patient 13 kann mittels einer Patientenlagerungsvorrichtung 15 der Magnetresonanzvorrichtung 10 in den Patientenaufnahmebereich 12 geschoben und/oder gefahren werden. Die Patientenlagerungsvorrichtung 15 weist hierzu einen innerhalb des Patientenaufnahmebereichs 12 bewegbar ausgestalteten Patiententisch 16 auf. Insbesondere ist hierbei der Patiententisch 16 in Richtung einer Längserstreckung des Patientenaufnahmebereichs 12 und/oder in z-Richtung bewegbar gelagert.

Die Scannereinheit 11, insbesondere die Magneteinheit, umfasst einen supraleitenden Grundmagneten 17 zu einem Erzeugen eines starken und insbesondere konstanten Grundmagnetfelds 18. Weiterhin weist die Scannereinheit 11, insbesondere die Magneteinheit, eine Gradientenspuleneinheit 19 zu einer Erzeugung von Magnetfeldgradienten auf, die für eine Ortskodierung während einer Bildgebung verwendet werden. Die Gradientenspuleneinheit 19 wird mittels einer Gradientensteuereinheit 20 der Magnetresonanzvorrichtung 10 gesteuert. Die Scannereinheit 11, insbesondere die Magneteinheit, umfasst weiterhin eine Hochfrequenzantenneneinheit 21 zu einer Anregung einer Polarisation, die sich in dem von dem Grundmagneten 17 erzeugten Grundmagnetfeld 18 einstellt. Die Hochfrequenzantenneneinheit 21 wird von einer Hochfrequenzantennensteuereinheit 22 der Magnetresonanzvorrichtung 10 gesteuert und strahlt hochfrequente Magnetresonanzsequenzen in den Patientenaufnahmebereich 12 der Magnetresonanzvorrichtung 10 ein. Die Hochfrequenzantenneneinheit 21 umfasst dabei die den Patientenaufnahmebereich 12 umgebende Umhausung 14. Insbesondere umfasst dabei die den Patientenaufnahmebereich 12 umgebende Umhausung 14 eine dem Patientenaufnahmebereich 12 zugewandte Seite der Hochfrequenzantenneneinheit 21.

Zu einer Steuerung des Grundmagneten 17, der Gradientensteuereinheit 20 und zur Steuerung der Hochfrequenzantennensteuereinheit 22 weist die Magnetresonanzvorrichtung 10 eine Systemsteuereinheit 23 auf. Die Systemsteuereinheit 23 steuert zentral die Magnetresonanzvorrichtung 10, wie beispielsweise das Durchführen einer vorbestimmten bildgebenden Gradientenechosequenz. Zudem umfasst die Systemsteuereinheit 23 eine nicht näher dargestellte Auswerteeinheit zu einer Auswertung von medizinischen Bilddaten, die während der Magnetresonanzuntersuchung erfasst werden. Die Systemsteuereinheit 23 weist zudem eine Speichereinheit 24, wie beispielsweise eine Datenbank, auf.

Des Weiteren umfasst die Magnetresonanzvorrichtung 10 eine Benutzerschnittstelle 25, die mit der Systemsteuereinheit 23 verbunden ist. Steuerinformationen wie beispielsweise Bildgebungsparameter, sowie rekonstruierte Magnetresonanzbilder können auf einer Ausgabeeinheit 26, beispielsweise auf zumindest einem Monitor, der Benutzerschnittstelle 25 für ein medizinisches Bedienpersonal angezeigt werden. Weiterhin weist die Benutzerschnittstelle 25 eine Eingabeeinheit 27 auf, mittels der Informationen und/oder Parameter während eines Messvorgangs von dem medizinischen Bedienpersonal eingegeben werden können.

Die Magnetresonanzvorrichtung 10 weist weiterhin eine Kamera 28 auf, die an einer Decke 29 eines Untersuchungsraums, in dem die Scannereinheit 11 der Magnetresonanzvorrichtung 10 angeordnet ist, angeordnet ist. Alternativ hierzu kann die Kamera 28 auch an einer Frontseite der Scannereinheit 11 angeordnet sein. Die Kamera 28 kann dabei eine 2D-Kamera oder auch eine 3D-Kamera umfassen. Mittels der Kamera 28 wird dabei der Patient 13 auf dem Patiententisch 16 erfasst. Insbesondere wird hierbei der Patient 13 auf dem Patiententisch 16 vor einem Einfahren in den Patientenaufnahmebereich 12 von der Kamera 28 erfasst.

Die dargestellte Magnetresonanzvorrichtung 10 kann selbstverständlich weitere Komponenten umfassen, die Magnetresonanzvorrichtungen 10 gewöhnlich aufweisen. Eine allgemeine Funktionsweise einer Magnetresonanzvorrichtung 10 ist zudem dem Fachmann bekannt, so dass auf eine detaillierte Beschreibung der weiteren Komponenten verzichtet wird.

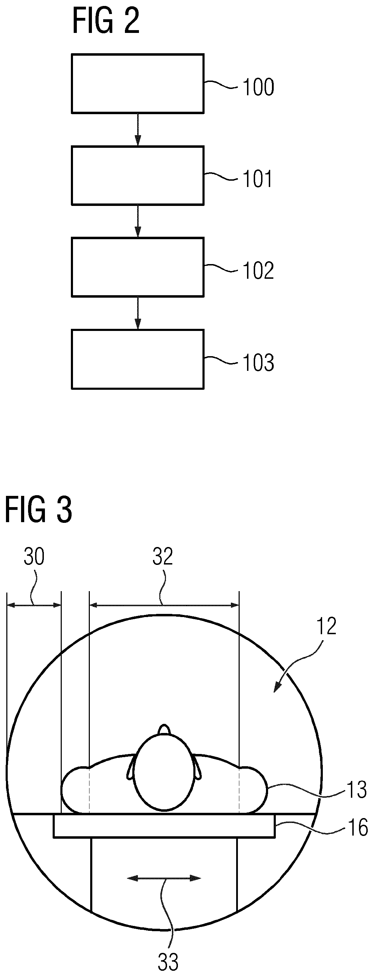

In Fig. 2 ist ein erfindungsgemäßes Verfahren zu einem Ermitteln eines Abstands 30 des Patienten 13 zu der den Patientenaufnahmebereich 12 umgebenden Umhausung 14, insbesondere der Hochfrequenzantenneneinheit 21, während einer Magnetresonanzuntersuchung des Patienten 13 dargestellt. Das Verfahren wird von einer Kontrolleinheit 31 überwacht und gesteuert. Die Kontrolleinheit 31 weist hierzu erforderliche Computerprogramme und/oder Software auf, die in einer Speichereinheit der Kontrolleinheit 31 gespeichert sind. Weiterhin weist die Kontrolleinheit 31 einen Prozessor auf, der zu einer Ausführung der Computerprogramme und/oder Software ausgebildet ist. Bei einem Ausführung der Computerprogramme und/oder Software durch den Prozessor der Kontrolleinheit 31 wird das Verfahren zum Ermitteln des Abstands 30 des Patienten 13 zu der den Patientenaufnahmebereich 12 umgebenden Umhausung 14, insbesondere der Hochfrequenzantenneneinheit 21, während der Magnetresonanzuntersuchung des Patienten 13 gestartet und von der Kontrolleinheit 31 gesteuert. Im vorliegendem Ausführungsbeispiel ist die Kontrolleinheit 31 von der Systemsteuereinheit 23 der Magnetresonanzvorrichtung 10 umfasst. Zudem kann die Kontrolleinheit 31 auch separat zur Systemsteuereinheit 23 ausgebildet sein.

In einem ersten Verfahrensschritt 100 erfolgt ein Bereitstellen einer ersten Größeninformation des Patienten 13, wobei die erste Größeninformation des Patienten 13 vor Beginn der Magnetresonanzuntersuchung bereitgestellt wird. Die erste Größeninformation des Patienten 13 umfasst hierbei bevorzugt eine Ausdehnung des Patienten 13. Insbesondere umfasst die erste Größeninformation des Patienten 13 einen Bereich in zumindest eine Raumrichtung 33, wobei dieser Bereich in der zumindest einen Raumrichtung 33 außerhalb eines FOVs 32 der Magnetresonanzvorrichtung 10 angeordnet ist. Bevorzugt umfasst die zumindest eine Raumrichtung 33 eine Querrichtung des Patiententischs 16 der Patientenlagerungsvorrichtung 15. Insbesondere ist hierbei eine Ausdehnung desjenigen Bereichs des Patienten 13 in Querrichtung von Bedeutung, der während der Magnetresonanzuntersuchung innerhalb des Patientenaufnahmebereichs 12 angeordnet ist. Insbesondere umfasst die erste Größeninformation des Patienten 13 eine Größeninformation und/oder Ausdehnungsinformation und/oder einen Umriss des Patienten 13, die in Querrichtung des Patiententischs 16 außerhalb des FOVs 32 angeordnet ist. Beispielsweise umfasst die erste Größeninformation eine Form und/oder eine Kontur von Armen des Patienten 13.

Die erste Größeninformation des Patienten 13 kann bereits bei einer Patientenregistrierung erfasst und bereitgestellt werden. Zudem kann die erste Größeninformation bereits in der Speichereinheit 24 und/oder einer Datenbank hinterlegt sein, beispielsweise bei einer ersten Größeninformation, die bei einer Voruntersuchung und/oder einer vorherigen Untersuchung ermittelt wurde. Zudem kann die erste Größeninformation auch während einer Vorbereitung des Patienten 13 für die Magnetresonanzuntersuchung erfasst und bereitgestellt werden, beispielsweise mittels der Kamera 28. Bevorzugt erfolgt das Bereitstellen der ersten Größeninformation des Patienten 13 mittels einer Bereitstellungseinheit 34 der Magnetresonanzvorrichtung 10. Die Bereitstellungseinheit 34 kann dabei die Kamera 28 und/oder die Datenbank bzw. die Speichereinheit 24 und/oder eine Registrierungseinheit und/oder weitere, dem Fachmann als sinnvoll erscheinende Einheiten umfassen. Die Registrierungseinheit kann beispielsweise die Kontrolleinheit 31 und/oder die Systemsteuereinheit 23 umfassen.

In einem zweiten Verfahrensschritt 101 erfolgt ein Erfassen von Magnetresonanzdaten des Patienten 13, wobei das Erfassen der Magnetresonanzdaten während der Magnetresonanzuntersuchung des Patienten 13 durchgeführt wird. Das Erfassen der Magnetresonanzdaten zur Bestimmung der zweiten Größeninformation des Patienten 13 wird mittels einer Erfassungseinheit 35 der Magnetresonanzvorrichtung 10 durchgeführt, wobei die Erfassungseinheit 35 die Scannereinheit 11 umfasst. Anhand der erfassten Magnetresonanzdaten wird eine zweite Größeninformation des Patienten 13 bestimmt, wobei das Bestimmen der zweiten Größeninformation des Patienten 13 von der Kontrolleinheit 31 durchgeführt wird.

Um die Magnetresonanzuntersuchung des Patienten 13 nicht zu stören, können die Magnetresonanzdaten zur Bestimmung der zweiten Größeninformation des Patienten 13 in Messpausen zwischen einzelnen Hochfrequenzpulsen der Magnetresonanzuntersuchung durchgeführt werden. Bevorzugt erfolgt dabei das Erfassen der Magnetresonanzdaten zur Bestimmung der zweiten Größeninformation des Patienten 13 mit einem maximalen FOV 32, um einen möglichst großen Bereich des Patienten 13 in den erfassten Magnetresonanzdaten abzudecken. Insbesondere werden hierbei von einem für die Magnetresonanzuntersuchung relevanten Bereich des Patienten 13 Magnetresonanzdaten zur Bestimmung der zweiten Größeninformation des Patienten 13 erfasst. Dabei umfasst das Erfassen der Magnetresonanzdaten zur Bestimmung der zweiten Größeninformation des Patienten 13 eine Justage-Messung und/oder eine Lokalisier-Messung. Vorzugsweise werden hierbei mehrere Schichten in z-Richtung angeregt und Magnetresonanzdaten dieser mehreren Schichten erfasst.

Alternativ hierzu kann es auch sein, dass das Erfassen der Magnetresonanzdaten zur Bestimmung der zweiten Größeninformation des Patienten 13 ein Erfassen von medizinischen und/oder diagnostischen Magnetresonanzdaten umfasst.

In einem daran anschließenden dritten Verfahrensschritt 102 erfolgt ein Ermitteln des Abstands 30 des Patienten 13 zu der den Patientenaufnahmebereich 12 umgebenden Umhausung 14, insbesondere der Hochfrequenzantenneneinheit 21, anhand der ersten Größeninformation des Patienten 13 und anhand der zweiten Größeninformation des Patienten 13. Dieser dritte Verfahrensschritt 103 wird mittels einer Ermittlungseinheit der Magnetresonanzvorrichtung 10 durchgeführt. Die Ermittlungseinheit umfasst im vorliegenden Ausführungsbeispiel die Kontrolleinheit 31.

In diesem dritten Verfahrensschritt 102 wird von der Ermittlungseinheit, insbesondere der Kontrolleinheit 31, der Abstand 30 des Patienten 13 zu der den Patientenaufnahmebereich 12 umgebenden Umhausung 14, insbesondere der Hochfrequenzantenneneinheit 21, mittels eines Körpermodells bestimmt, wobei das Körpermodell anhand der ersten Größeninformation des Patienten 13 und anhand der zweiten Größeninformation des Patienten 13 ermittelt und/oder erstellt wird. Dabei wird beispielsweise mittels der zweiten Größeninformation des Patienten 13 zunächst eine exakte Position des Patienten 13 innerhalb des Patientenaufnahmebereichs 12 bestimmt. Des Weiteren wird beispielsweise aus der zweiten Größeninformation des Patienten 13 ein Körpermodell für den innerhalb des FOVs befindlichen Teilbereich des Patienten 13 erstellt und dieses anhand der ersten Größeninformation des Patienten 13 mit den Teilbereichen des Patienten 13, die außerhalb des FOVs 32 angeordnet sind, ergänzt, siehe Fig. 3. Beispielsweise kann hierbei mittels der zweiten Größeninformation des Patienten 13 ein Torso mit einer sichtbare innere Armgrenze bereitgestellt werden und mittels der ersten Größeninformation der Patienten die Arme zur Vervollständigung des Körpermodells hinzugefügt werden. Anhand des Körpermodells und der Position des Patienten 13 innerhalb des Patientenaufnahmebereichs 12 wird dann von der Ermittlungseinheit, insbesondere der Kontrolleinheit 31, der Abstand 30 des Patienten 13 zu der den Patientenaufnahmebereich 12 umgebenden Umhausung 14, insbesondere der Hochfrequenzantenneneinheit 21, ermittelt und/oder bestimmt.

Daran anschließend wird in einem vierten, insbesondere optionalen, Verfahrensschritt 103 der ermittelte Abstand 30 des Patienten 13 zu der den Patientenaufnahmebereich 12 umgebenden Umhausung 14, insbesondere der Hochfrequenzantenneneinheit 21, mit einem Sicherheitsabstand verglichen. Sofern der ermittelte Abstand 30 dabei kleiner ist als der Sicherheitsabstand, wird in diesem vierten Verfahrensschritt 103 eine Sicherheitsmaßnahme von der Ermittlungseinheit, insbesondere der Kontrolleinheit 31, eingeleitet und/oder durchgeführt. Beispielsweise beträgt der Sicherheitsabstand 5 mm. Ist der Abstand 30 des Patienten 13 zu der den Patientenaufnahmebereich 12 umgebenden Umhausung 14, insbesondere der Hochfrequenzantenneneinheit 21, kann es zu unerwünschten Verletzungen, insbesondere Verbrennungen, des Patienten 13 kommen. Eine Sicherheitsmaßnahme kann beispielsweise sein, dass eine HF-Leistung von auszuspielenden HF-Pulsen der Hochfrequenzantenneneinheit 21 reduziert wird. Dies kann beispielsweise zu Pausen nach jeder Messung führen und/oder zu einer Reduzierung einer Schichtanzahl und/oder einer Reduzierung der Flipwinkel usw.

Ist dagegen der Abstand des Patienten 13 zu der den Patientenaufnahmebereich 12 umgebenden Umhausung 14, insbesondere der Hochfrequenzantenneneinheit 21, größer als der Sicherheitsabstand, wird die Magnetresonanzuntersuchung mit den ursprünglichen Einstellungen wie geplant weiter durchgeführt.

Während der Magnetresonanzuntersuchung des Patienten 13 werden der zweite bis vierte Verfahrensschritt 101, 102, 103 bis zum Beenden der Magnetresonanzuntersuchung wenigstens einmal wiederholt. Bevorzugt werden von der Kontrolleinheit 31 der zweite bis vierte Verfahrensschritt 102, 103, 104 mehrmals wiederholt, um Positionsänderungen des Patienten 13 und damit auch eine Änderung des Abstands 30 des Patienten 13 zu der den Patientenaufnahmebereich 12 umgebenden Umhausung 14, insbesondere der Hochfrequenzantenneneinheit 21, regelmäßig zu erfassen und zu überwachen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zu einem Ermitteln eines Abstands eines Patienten zu einer einen Patientenaufnahmebereich umgebenden Umhausung einer Magnetresonanzvorrichtung während einer Magnetresonanzuntersuchung, umfassend die folgenden Verfahrensschritte:
- Bereitstellen einer ersten Größeninformation des Patienten, wobei die erste Größeninformation vor Beginn der Magnetresonanzuntersuchung bereitgestellt wird,
- Erfassen von Magnetresonanzdaten des Patienten während der Magnetresonanzuntersuchung und Bestimmen einer zweiten Größeninformation des Patienten anhand der erfassten Magnetresonanzdaten, und
- Ermitteln des Abstands des Patienten zu der den Patientenaufnahmebereich umgebenden Umhausung anhand der ersten Größeninformation des Patienten und anhand der zweiten Größeninformation des Patienten, wobei zum Bestimmen des Abstands des Patienten zu der den Patientenaufnahmebereich umgebenden Umhausung ein Körpermodell des Patienten anhand der ersten Größeninformation und anhand der zweiten Größeninformation von einem innerhalb des Patientenaufnahmebereichs angeordneten Teilbereich des Patienten bestimmt wird.

2. Verfahren nach Anspruch 1,
**dadurch gekennzeichnet, dass** die erste Größeninformation mittels einer Kamera bereitgestellt wird.

3. Verfahren nach einem der vorhergehenden Ansprüche,
**dadurch gekennzeichnet, dass** die erste Größeninformation mittels einer Datenbank und/oder einer Patientenregistrierung bereitgestellt wird.

4. Verfahren nach einem der vorhergehenden Ansprüche,
**dadurch gekennzeichnet, dass** die erste Größeninformation einen Bereich in zumindest eine Raumrichtung umfasst, wobei dieser Bereich in der zumindest einen Raumrichtung außerhalb des FOVs der Magnetresonanzvorrichtung angeordnet ist.

5. Verfahren nach einem der vorhergehenden Ansprüche,
**dadurch gekennzeichnet, dass** das Erfassen von Magnetresonanzdaten zur Bestimmung der zweiten Größeninformation des Patienten mit einem maximalen FOV durchgeführt wird.

6. Verfahren nach einem der vorhergehenden Ansprüche,
**dadurch gekennzeichnet, dass** das Erfassen der Magnetresonanzdaten zur Bestimmung der zweiten Größeninformation des Patienten für einen für die Magnetresonanzuntersuchung relevanten Bereich des Patienten durchgeführt wird.

7. Verfahren nach einem der vorhergehenden Ansprüche,
**dadurch gekennzeichnet, dass** das Erfassen der Magnetresonanzdaten zur Bestimmung der zweiten Größeninformation des Patienten eine Justage-Messung und/oder eine Lokalisier-Messung umfasst.

8. Verfahren nach einem der vorhergehenden Ansprüche,
**dadurch gekennzeichnet, dass** das das Erfassen der Magnetresonanzdaten zur Bestimmung der zweiten Größeninformation des Patienten bis zum Beenden der Magnetresonanzuntersuchung wenigstens einmal wiederholt wird.

9. Verfahren nach einem der vorhergehenden Ansprüche,
**dadurch gekennzeichnet, dass** der ermittelte Abstand des Patienten zu der den Patientenaufnahmebereich umgebenden Umhausung mit einem Sicherheitsabstand verglichen, und, sofern der ermittelte Abstand kleiner ist als der Sicherheitsabstand, zumindest eine Sicherheitsmaßnahme durchgeführt wird.

10. Magnetresonanzvorrichtung, die zu einem Ausführen des Verfahrens zu einem Bestimmen eines Abstands eines Patienten zu einer einen Patientenaufnahmebereich umgebenden Umhausung, insbesondere einer Hochfrequenzantenneneinheit, während einer Magnetresonanzuntersuchung nach einem der Ansprüche 1 bis 9 ausgebildet ist, umfassend:
- eine Bereitstellungseinheit, die zu einem Bereitstellen einer ersten Größeninformation des Patienten ausgebildet ist,
- eine Erfassungseinheit, die zu einem Erfassen von Magnetresonanzdaten zur Bestimmung einer zweiten Größeninformation des Patienten ausgebildet ist, und
- eine Ermittlungseinheit, die zu einem Ermitteln eines Abstands des Patienten zu der den Patientenaufnahmebereich umgebenden Umhausung ausgebildet ist.

11. Computerprogrammprodukt, welches ein Steuerprogramm umfasst und direkt in einen Speicher einer programmierbaren Steuereinheit ladbar ist, mit Programmmitteln, um ein Verfahren zu einem Bestimmen eines Abstands eines Patienten zu einer einen Patientenaufnahmebereich umgebenden Umhausung während einer Magnetresonanzuntersuchung nach einem der Ansprüche 1 bis 9 zu steuern, wenn das Programm in der Steuereinheit ausgeführt wird.

## Claims

1. Method for ascertaining a distance between a patient and an enclosure, which surrounds a patient receiving region, of a magnetic resonance apparatus during a magnetic resonance examination, comprising the following method steps:
- providing a first item of size information of the patient, wherein the first size information is provided before starting the magnetic resonance examination,
- capturing magnetic resonance data of the patient during the magnetic resonance examination and determining a second item of size information of the patient on the basis of the captured magnetic resonance data, and
- ascertaining the distance between the patient and the enclosure surrounding the patient receiving region on the basis of the first size information of the patient and on the basis of the second size information of the patient, wherein, in order to determine the distance between the patient and the enclosure surrounding the patient receiving region, a body model of the patient is determined on the basis of the first size information and on the basis of the second size information, from a subregion of the patient arranged within the patient receiving region.

2. Method according to claim 1,
**characterised in that** the first size information is provided by means of a camera.

3. Method according to one of the preceding claims,
**characterised in that** the first size information is provided by means of a database and/or a patient registration.

4. Method according to one of the preceding claims,
**characterised in that** the first size information comprises a region in at least one spatial direction, wherein this region in the at least one spatial direction is arranged outside the FOV of the magnetic resonance apparatus.

5. Method according to one of the preceding claims,
**characterised in that** the capturing of magnetic resonance data for determining the second size information of the patient is performed with a maximum FOV.

6. Method according to one of the preceding claims,
**characterised in that** the capturing of the magnetic resonance data for determining the second size information of the patient is performed for a region of the patient that is relevant to the magnetic resonance examination.

7. Method according to one of the preceding claims,
**characterised in that** the capturing of the magnetic resonance data for determining the second size information of the patient comprises an adjustment measurement and/or a localiser measurement.

8. Method according to one of the preceding claims,
**characterised in that** the capturing of the magnetic resonance data for determining the second size information of the patient is repeated at least once until the conclusion of the magnetic resonance examination.

9. Method according to one of the preceding claims,
**characterised in that** the ascertained distance between the patient and the enclosure surrounding the patient receiving region is compared with a safety distance, and, if the ascertained distance is smaller than the safety distance, at least one safety measure is performed.

10. Magnetic resonance apparatus, which is embodied to carry out the method for determining a distance between a patient and an enclosure surrounding a patient receiving region, in particular a radiofrequency antenna unit, during a magnetic resonance examination according to one of claims 1 to 9, comprising:
- a provision unit, which is embodied to provide a first item of size information of the patient,
- a capture unit, which is embodied to capture magnetic resonance data for determining a second item of size information of the patient, and
- an ascertaining unit, which is embodied to ascertain a distance of the patient from the enclosure surrounding the patient receiving region.

11. Computer program product, which comprises a control program and can be loaded directly into a memory of a programmable control unit, with program means in order to control a method for determining a distance between a patient and an enclosure surrounding a patient receiving region during a magnetic resonance examination according to one of claims 1 to 9, when the program is executed in the control unit.

## Revendications

1. Procédé de détermination d'une distance d'un patient à une enceinte entourant une zone de réception de patient d'une installation de résonance magnétique pendant un examen par résonance magnétique comprenant les stades de procédé suivants :
- se procurer une première information de dimension du patient, dans lequel on se procure la première information de dimension avant le début de l'examen par résonance magnétique,
- saisir des données de résonance magnétique du patient pendant l'examen par résonance magnétique et déterminer une deuxième information de dimension du patient à l'aide des données de résonance magnétique saisies, et
- déterminer la distance du patient à l'enceinte entourant la zone de réception de patient à l'aide de la première information de dimension du patient et à l'aide de la deuxième information de dimension du patient,
dans lequel pour la détermination de la distance du patient à l'enceinte entourant la zone de réception du patient, on détermine, à l'aide de la première information de dimension et à l'aide de la deuxième information de dimension, un modèle de corps du patient par une zone partielle du patient disposée à l'intérieur de la zone de réception du patient.

2. Procédé suivant la revendication 1,
**caractérisé en ce que** l'on se procure la première information de dimension au moyen d'une caméra.

3. Procédé suivant l'une des revendications précédentes,
**caractérisé en ce que** l'on se procure la première information de dimension au moyen d'une base de données et/ou d'un enregistrement de patient.

4. Procédé suivant l'une des revendications précédentes,
**caractérisé en ce que** la première information de dimension comprend une zone dans au moins une direction de l'espace, dans lequel cette zone est disposée dans la au moins une direction de l'espace à l'extérieur du FOV de l'installation de résonance magnétique.

5. Procédé suivant l'une des revendications précédentes,
**caractérisé en ce que** l'on effectue la saisie de données de résonance magnétique de la deuxième grandeur de dimension du patient avec un FOV maximum.

6. Procédé suivant l'une des revendications précédentes,
**caractérisé en ce que** l'on effectue la saisie de données de résonance magnétique pour la détermination de la deuxième information de dimension du patient pour une zone du patient pertinente pour l'examen par résonance magnétique.

7. Procédé suivant l'une des revendications précédentes,
**caractérisé en ce que** la saisie des données de résonance magnétique pour la détermination de la deuxième information de dimension du patient comprend une mesure de réglage et/ou une mesure de localisation.

8. Procédé suivant l'une des revendications précédentes,
**caractérisé en ce que** l'on répète au moins une fois la saisie des données de résonance magnétique pour la détermination de la deuxième information de dimension du patient jusqu'à ce qu'il soit mis fin à l'examen par résonance magnétique.

9. Procédé suivant l'une des revendications précédentes, **caractérisé en ce que** l'on compare la distance déterminée du patient à l'enceinte entourant la zone de réception du patient à une distance de sécurité, et dans la mesure où la distance déterminée est plus petite que la distance de sécurité, on prend au moins une mesure de sécurité.

10. Installation de résonance magnétique, qui est constituée pour l'exécution du procédé de détermination d'une distance d'un patient à une enceinte entourant une zone de réception de patient, en particulier d'une unité d'antenne à haute fréquence, pendant un examen par résonance magnétique suivant l'une des revendications 1 à 9, comprenant :
- une unité de mise à disposition, qui est constituée pour une mise à disposition d'une première information de dimension du patient,
- une unité de saisie, qui est constituée pour une saisie de données de résonance magnétique pour la détermination d'une deuxième information de dimension du patient,
- une unité de détermination, qui est constituée pour une détermination d'une distance du patient à l'enceinte entourant la zone de réception du patient.

11. Produit de programme d'ordinateur, qui comprend un programme de commande et qui peut être chargé directement dans une mémoire d'une unité de commande programmable, comprenant des moyens de programme pour commander un procédé de détermination d'une distance d'un patient à une enceinte entourant une zone de réception du patient de patient pendant un examen par résonance magnétique suivant l'une des revendications 1 à 9, lorsque le programme est exécuté dans l'unité de commande.
